# EUROPÄISCHE PATENTSCHRIFT

(11) **EP 2 144 304 B1**
(45) Veröffentlichungstag und Bekanntmachung des Hinweises auf die Patenterteilung: **07.08.2019**
(21) Anmeldenummer: 09007712.4
(22) Anmeldetag: 10.06.2009
(51) Int. Cl.: H01L 31/18, H01L 27/142, B28D 5/00, B23K 26/03

(54) **Strukturierungsvorrichtung für die Strukturierung von plattenförmigen Elementen, insbesondere von Dünnschicht-Solarmodulen, entsprechendes Strukturierungs-verfahren sowie Verwendung deselben**
Structuring device for structuring board-shaped elements, particularly thin layer solar modules, structuring process and use
Dispositif de structuration pour la structuration d'éléments en forme de plaques, notamment de modules solaires à couches minces, procédé de structuration et utilisation

(30) Priorität: 10.07.2008 DE 102008032555
(43) Veröffentlichungstag der Anmeldung: 13.01.2010
(73) Patentinhaber: Innolas Solutions GmbH, 82152 Krailling (DE)
(72) Erfinder: Grundmüller, Richard, 87663 Lengenwang (DE)
(74) Vertreter: Pfenning, Meinig & Partner mbB

(56) Entgegenhaltungen:
- WO-A1-2008/056116
- WO-A2-2007/144565
- DE-A1-102006 051 556
- JP-A- S6 310 073
- JP-A- H11 298 017
- JP-A- 2006 041 322
- US-A- 5 373 137
- US-A1- 2003 029 848
- US-A1- 2008 012 189

## Beschreibung

Die vorliegende Erfindung bezieht sich auf eine Strukturierungsvorrichtung (sowie auf ein entsprechendes Strukturierungsverfahren) zur Strukturierung von plattenförmigen Elementen, insbesondere von Solarmodulen in Form von Dünnschicht-Solarmodulen gemäß dem Oberbegriff der unabhängigen Ansprüche. CIS-Dünnschichtsolarzellen auf Glassubstraten oder auf Foliensubstraten haben aufgrund ihrer Flexibilität, ihrer Leichtheit und ihrer Effizienz in den letzten Jahren eine immer größere Verbreitung gefunden. Ein Vorteil dieser Dünnschicht-Solarmodule ist auch die Möglichkeit, auf einem gemeinsamen, elektrisch isolierenden Substrat einzelne Zellen bereits während des Herstellungsprozesses elektrisch (meist in Serie) zu verschalten. Für eine
solche elektrische Verschaltung sind dabei in der Regel mehrere Strukturierungsschritte notwendig: Nach Abscheiden des Rückkontaktes (häufig aus Molybdän) wird dieser in einzelne elektrisch voneinander getrennte Zellen aufgeteilt. Nachdem die Zwischenschichten (z.B. CIS-Absorber, Puffer- und (i-)ZnO-Schicht) aufgebracht sind, müssen diese Schichten auf dem Rand der Nachbarzelle bis zum Molybdän durchtrennt werden. In einem weiteren Strukturierungsschritt muss dann der nachfolgend aufgebrachte Frontkontakt (beispielsweise leitfähiges ZnO:Al) aufgetrennt werden, um die kurzgeschlossenen Zellen wieder aufzuteilen.

Für diese mehreren Strukturierungsschritte ist es notwendig, in die einzelnen Schichten des Dünnschicht-Solarmoduls mehrere parallel zueinander und mit konstantem Abstand voneinander verlaufende Spuren einzubringen. Zum Einbringen dieser Spuren werden, je nach konkreter Profilanforderungen einer solchen Spur entweder mechanische Strukturierungswerkzeuge (wie beispielsweise mechanische Stichel oder Ritznadeln) oder Strukturierungswerkzeuge in Form von Laserbearbeitungseinheiten verwendet. Eine dergestaltige Einbringung von Spuren in die Schichten von Solarmodulen ist beispielsweise in der DE 10 2006 051 556 A1 beschrieben.

Eine grundlegende Schwierigkeit beim Einbringen der Spuren liegt darin begründet, dass die Solarzellenmodule bei ihrer Herstellung mehrere Prozessschritte, die teilweise auch unter hohen Temperaturen ablaufen, durchlaufen müssen. So erfolgt beispielsweise die Einbringung von ersten parallelen Spuren in eine erste Schicht eines Solarzellenmoduls (beispielsweise in den Rückseitenkontakt) mittels einer ersten Bearbeitungsvorrichtung auf Basis eines Laserkopfes (oder mehrerer in konstantem Abstand voneinander parallel arbeitender Laserköpfe). In einem weiteren Prozessschritt durchläuft das so strukturierte Solarmodul einen Hochtemperaturschritt. Hierdurch kommt es temperaturbedingt zu einem (geringfügigen) Verziehen des Solarmoduls, so dass die ursprünglich parallel eingebrachten Spuren des Laserprozessschrittes nach dem Hochtemperaturschritt nicht mehr exakt parallel sind. In einem weiteren, dritten Prozessschritt sollen dann (beispielsweise mittels eines mechanischen Prozessschrittes) in einer weiteren Schicht (beispielsweise einer Zwischenschicht) erneut parallele Spuren in das Solarmodul einstrukturiert werden. Hierbei ist entscheidend, dass diese parallelen Spuren in genau definierten Abständen und parallel zu denjenigen Spuren, die im ersten Prozessschritt (Laserprozessschritt) eingebracht wurden, einstrukturiert werden.

Aus der WO 2008/056116 A1 ist eine Strukturierungsvorrichtung mit mindestens einer Optikeinheit als Strukturierungswerkzeug und mindestens einem Ausrichtungsdetektorsystem bekannt, wobei die Strukturierungsvorrichtung ein genaues Positionieren von Laserritzlinien in einer dünnen oberen Materialschicht ermöglicht, die eine oder mehrere andere untere Schichten überzieht, in denen bereits Linien zum Zweck der Herstellung von Solarzellenplatten geritzt sind. Aus der JP S63 010073 A ist eine Schneidevorrichtung mit mehreren Schneidewerkzeugen in Form von Brennern bekannt, wobei die Schneidewerkzeuge gleichzeitig und automatisch während der Strukturierung in mehrere verschiedene Richtungen bewegt werden können und somit in kurzer Bearbeitungszeit viele verschiedene Schnittformen erzeugt werden können.

Aufgabe der vorliegenden Erfindung ist es daher, eine Strukturierungsvorrichtung für die Strukturierung von plattenförmigen Elementen, insbesondere Dünnschicht-Solarmodulen, zur Verfügung zu stellen, welche auf einfache, effiziente und zuverlässige Art und Weise die Einbringung einer Mehrzahl von weiteren Spuren in das plattenförmige Element so erlaubt, dass diese weiteren bzw. neu einzubringenden Spuren in definiertem Abstand von (insbesondere parallel zu und in konstantem Abstand von) von bereits in das plattenförmige Element einstrukturierten Spuren angeordnet sind.

Diese Aufgabe wird durch eine Strukturierungsvorrichtung gemäß Anspruch 1 sowie durch ein Strukturierungsverfahren gemäß Anspruch 12 gelöst. Vorteilhafte Ausgestaltungen der erfindungsgemäßen Vorrichtung bzw. des erfindungsgemäßen Verfahrens lassen sich jeweils den abhängigen Patentansprüchen entnehmen.

Nachfolgend wird die erfindungsgemäße Strukturierungsvorrichtung (bzw. das erfindungsgemäße Strukturierungsverfahren) zunächst allgemein und dann anhand eines speziellen Ausführungsbeispiels beschrieben. Die einzelnen beim Ausführungsbeispiel in Kombination miteinander verwirklichten Merkmale müssen dabei nicht in genau dieser Kombination vorliegen, sondern können im Rahmen der vorliegenden Erfindung auch in beliebigen anderen Kombinationen realisiert sein bzw. verwendet werden.

Die vorliegende Erfindung basiert auf der grundlegenden Idee, eine Vielzahl von bereits in das plattenförmige Element einstrukturierten Spuren jeweils in mehrere lokale Nahbereiche (eines einzigen globalen Spurenbereichs) einzuteilen bzw. diese mehreren lokalen Bereiche getrennt voneinander zu betrachten. Nachfolgend werden bereits in das plattenförmige Element eingebrachte Spuren grundsätzlich durch einen Hochstrich bezeichnet und die einzelnen Spuren eines lokalen Bereiches auch als Spurengruppe bezeichnet. So werden beispielsweise alle in das plattenförmige Element bereits einstrukturierte Spuren in mehrere (lokale) Spurengruppen SG1' bis SGm' unterteilt, wobei jede solche Spurengruppe mehrere einzelne Spuren (beispielsweise vier bis sechs einzelne Spuren) umfasst.

Die beispielsweise durch Temperatureffekte am plattenförmigen Element mit bereits eingebrachten Spuren bewirkten Verzerrungen können nun näherungsweise wie folgt betrachtet werden: Im lokalen Nahbereich, also im Bereich einer einzelnen Spurengruppe SG' kann davon ausgegangen werden, dass der konstante Abstand der einzelnen Spuren einer Spurengruppe durch die Verzerrung näherungsweise nicht beeinträchtigt wird. Näherungsweise verlaufen somit sämtliche Spuren einer einzelnen Spurengruppe in konstantem Abstand voneinander und parallel zueinander. Hierbei muss der Verlauf einer einzelnen Spur einer solchen Spurengruppe nicht in Form einer Geraden vorliegen und tut dies aufgrund der Verzerrung des Solarmodules in der Regel auch nicht: die einzelnen Spuren einer Spurengruppe können somit durchaus leicht gekrümmt verlaufen, jedoch zueinander parallel und in konstantem Abstand.

Global gesehen, d.h. über sämtliche Spurengruppen SG' des plattenförmigen Elements, verlieren nun die einzelnen Spuren unterschiedlicher Spurengruppen ihren parallelen Verlauf zueinander bzw. ihren Verlauf mit konstantem Abstand voneinander. Mit anderen Worten verlaufen zwar (näherungsweise) jeweils die einzelnen Spuren der unterschiedlichen Spurengruppen innerhalb ein und derselben ihrer Spurengruppe gesehen parallel zueinander, die einzelnen Spuren unterschiedlicher Spurengruppen (insbesondere weit entfernt voneinander eingebrachter Spurengruppen) verlaufen jedoch nicht mehr parallel zueinander, sondern zeigen aufgrund der vorbeschriebenen Verzerrungen unterschiedliche Verläufe bzw. unterschiedliches Krümmungsverhalten.

Basierend auf diesem Grundgedanken weist nun die erfindungsgemäße Strukturierungsvorrichtung mehrere (bevorzugt: vier bis sechs) unabhängig voneinander steuerbare Strukturierungseinheiten auf, wobei jede dieser Strukturierungseinheiten ihrerseits mehrere (bevorzugt: vier bis sechs) einzelne Strukturierungswerkzeuge umfasst. Bei den einzelnen Strukturierungswerkzeugen einer solchen Strukturierungseinheit kann es sich beispielsweise um mechanische Strukturierungswerkzeuge wie Ritzköpfe mit jeweils einer mechanischen Ritznadel handeln, alternativ dazu sind jedoch auch Strukturierungswerkzeuge in Form von Laserbearbeitungseinheiten denkbar, die dann jeweils einen Laser mit nachgeschalteter Optik (zur Einstrahlung des Laserstrahls auf das plattenförmige Element) aufweisen.

Die einzelnen Strukturierungswerkzeuge einer einzelnen Strukturierungseinheit sind dabei bevorzugt in konstantem Abstand voneinander und relativ zueinander fixiert so angeordnet, dass mit den mehreren Strukturierungswerkzeugen dieser Strukturierungseinheit mehrere parallele Spuren (mit jeweils konstantem und gleichem Abstand benachbarter Spuren) in das plattenförmige Element eingebracht werden können.

Mindestens zwei Strukturierungswerkzeuge mindestens einer der Strukturierungseinheiten sind erfindungsgemäß so ausgestaltet, dass sie hinsichtlich der Ausdehnung, Tiefe und/oder Form der durch sie in das plattenförmige Element einbringbaren Spuren unabhängig voneinander regelbar sind: So kann insbesondere der Anpressdruck zweier Strukturierungswerkzeuge einer einzelnen Strukturierungseinheit in Form von Ritzköpfen unabhängig voneinander geregelt werden und somit auf lokal im plattenförmigen Element vorliegende unterschiedliche Verhältnisse flexibel reagiert werden.

Der wesentliche Aspekt der erfindungsgemäßen Umsetzung des vorbeschriebenen Grundgedankens besteht nun darin, dass die einzelnen Strukturierungseinheiten unabhängig voneinander ansteuerbar und bewegbar sind: Mit jeder Strukturierungseinheit kann somit eine Spurengruppe bezüglich ihres Verlaufes unabhängig vom Verlauf der Spurengruppen anderer Strukturierungseinheiten in das plattenförmige Element einstrukturiert werden. Die einzelnen Strukturierungseinheiten können hierfür jeweils separat mit eigenen Motorsteuerungen versehen sein, so dass der Abstand jeweils benachbarter Strukturierungseinheiten während des Einbringens der jeweiligen Spurengruppen variiert werden kann.

Somit können erfindungsgemäß mit einer Spurerfassungseinheit (beispielsweise einer Kamera mit angeschlossener Bildverarbeitungsvorrichtung) die Verläufe von bereits in das plattenförmige Element eingebrachten Spuren bestimmt und hinsichtlich ihres Verlaufs ausgewertet werden, indem zunächst die erfassten Spuren in Spurengruppen SG1' bis SGm' (m = 2, 3, 4, ...) mit jeweils mehreren Einzelspuren eingeteilt werden. Jeder dieser Spurengruppen kann dann eine Strukturierungseinheit mit einer der Spurenzahl der jeweiligen Spurengruppe entsprechenden Anzahl von Strukturierungswerkzeugen zugeordnet werden. Mit Hilfe einer Spursteuereinheit, die die einzelnen Strukturierungseinheiten ansteuert, kann dann jede Strukturierungseinheit (unabhängig von den anderen Strukturierungseinheiten) in Abhängigkeit vom Verlauf ihrer zugeordneten Spurengruppe SG' so gesteuert werden, dass die mit den Strukturierungswerkzeugen der Strukturierungseinheit neu einzubringenden Spuren (neu einzubringende Spurengruppe SG) jeweils parallel und in konstantem Abstand zu den erfassten, bereits eingebrachten Spuren der zugehörigen Spurengruppe SG' eingebracht werden.

Die Einbringung der verschiedenen Spurengruppen SG1 bis SGm (neu einzubringende Spurengruppen) erfolgt dabei durch die unabhängige Ansteuerung der einzelnen Strukturierungseinheiten und die Bewegung dieser Einheiten unabhängig voneinander, d.h. mit variablem Abstand zueinander. Auf die vorbeschriebene Art und Weise kann, auch wenn aufgrund der vorbeschriebenen Verzerrungen zwischen den einzelnen bereits eingebrachten Spurengruppen SG1' bis SGm' senkrecht zur Spurrichtung gesehen variable Abstände auftreten, dennoch zu jeder einzelnen Spur jeder Spurengruppe SG' eine zu dieser entlang des gesamten Spurverlaufs parallele und in konstantem Abstand angeordnete neue Spur eingebracht werden. Aufgrund der Verwendung mehrerer unabhängig voneinander bewegbarer und steuerbarer Strukturierungseinheiten kann die an dem bereits eingebrachten Spuren orientierte Einbringung der neuen Spuren einfach und mit hoher Parallelität erfolgen, so dass ein schnelles Einbringen einer Vielzahl von Spuren in vordefinierter Art und Weise in das zu bearbeitende plattenförmige Element möglich ist.

Nachfolgend wird die vorliegende Erfindung anhand eines Ausführungsbeispiels beschrieben.

Dazu zeigen:
- Figur 1: den grundlegenden Aufbau der wesentlichen Prozesseinheit der beispielhaften Strukturierungsvorrichtung.
- Figur 2: ein plattenförmiges Element mit bereits eingebrachten Spuren sowie mehrere aufeinanderfolgende Prozesseinheiten der beispielhaften Strukturierungsvorrichtung.
- Figur 3: das plattenförmige Element aus Figur 2, in das anhand der Orientierung am Verlauf bereits vorhandener Spuren neue Spuren einstrukturiert wurden.
- Figur 4: ein einzelnes Strukturierungswerkzeug einer der in dem Ausführungsbeispiel von Figur 1 eingesetzten Strukturierungseinheiten.

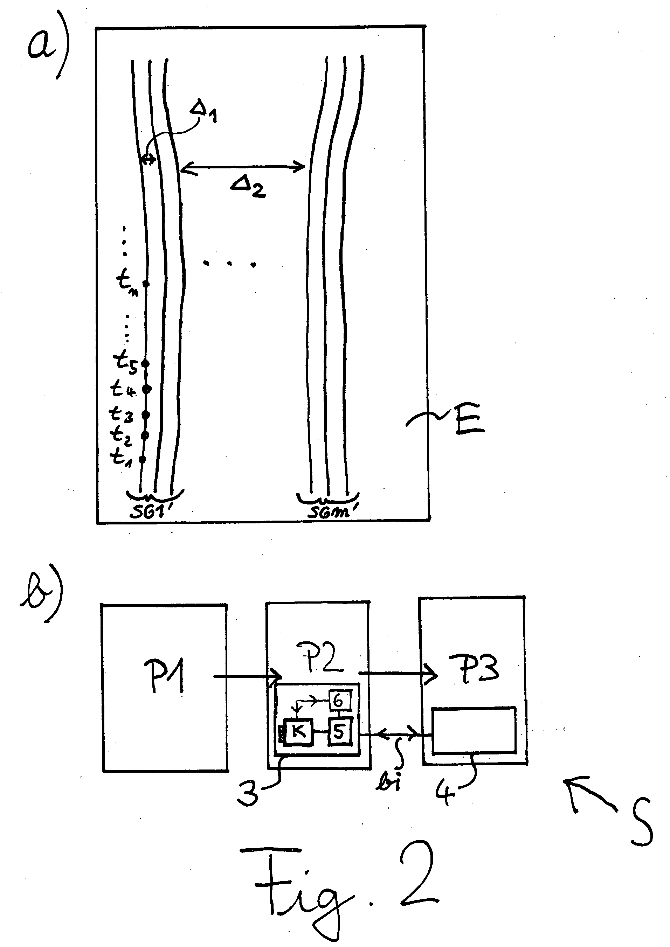

Figur 2b skizziert den grundlegenden Aufbau einer erfindungsgemäßen Strukturierungsvorrichtung: In einer ersten Prozesseinheit P1 wird ein zu bearbeitendes plattenförmiges Element E in Form eines Dünnschicht-Solarmoduls, hier CIS-Solarmoduls (nachfolgend: Solarmodul) einem ersten Bearbeitungsschritt unterzogen. Bei diesem ersten Bearbeitungsschritt wird eine Vielzahl von zueinander parallelen Spuren in eine erste Schicht des Solarmoduls (Rückkontaktschicht) einstrukturiert. Die Einstrukturierung dieser ersten Spuren geschieht hier mit einem Laserkopf, der hier beispielsweise insgesamt 25 parallele Spuren mit jeweils demselben Abstand zwischen zwei benachbarten Spuren in das Solarmodul einstrukturiert (es sind jedoch natürlich auch andere Spurenzahlen möglich).

Nachfolgend wird (wie in der gesamten Beschreibung der Erfindung) unter dem Begriff des Abstandes folgendes verstanden (siehe auch Figur 2a)): Der Abstand Δ₁ zwischen zwei benachbarten einzelnen Spuren einer Spurengruppe SG' (bzw. bei neu einzubringenden Spurengruppen: SG) an einer beliebigen Stützstelle einer dieser Spuren tᵢ (i = 1, 2, ..., n) ist die minimale Entfernung von dieser Stützstelle zu der Menge aller möglichen Stützstellen der anderen Spur (minimaler Abstand einer Spur von der Nachbarspur senkrecht zum Spurverlauf). Bei der folgenden Betrachtung wird davon ausgegangen, dass die Abstände Δ₁ jeweils benachbarter Spuren ein und derselben Spurengruppe SG' für alle Spurenpaare dieser Spurengruppe und über den gesamten Verlauf der Spuren längs des plattenförmigen Elementes näherungsweise dieselben und konstant sind.

Unter dem Abstand Δ₂ zweier unterschiedlicher Spurengruppen (beispielsweise der Spurengruppe SG1' und der Spurengruppe SGm' in Figur 2a)) wird die minimale Entfernung einer beliebigen, jedoch definierten Stützstelle tᵢ (i = 1, 2, 3, ...) einer definierten Spur der einen Spurengruppe (z.B. SG1') zu der Menge aller Stützstellen auf derselben Spur der anderen Spurengruppe (z.B. SGm') verstanden. Die Messung des Abstandes Δ₂ der Spurengruppen erfolgt dabei jeweils zwischen denselben Spuren der jeweiligen Spurengruppe, d.h. wenn z.B. wie im vorgestellten Beispiel jede Spurengruppe aus jeweils fünf Einzelspuren besteht, so wird der Abstand Δ₂ zwischen zwei Spurengruppen beispielsweise zwischen jeweils der ersten Spur der beiden Spurengruppen bestimmt. Bei der nachfolgenden Betrachtungsweise wird nun davon ausgegangen, dass der Spurenabstand Δ₂ zwischen zwei unterschiedlichen Spurengruppen SG' aufgrund der vorbeschriebenen Verzerrungseffekte entlang des Verlaufes der einzelnen Spuren variiert, also im Gegensatz zu dem Abstand Δ₁ zwischen zwei benachbarten Spuren innerhalb einer Spurengruppe nicht konstant bleibt.

Aufgrund des in der ersten Prozesseinheit P1 nach der Einbringung der ersten Spuren erfolgenden Hochtemperaturschrittes zur Aufbringung weiterer Schichten (Zwischenschichten) des Solarmoduls verlässt das Solarmodul E die erste Prozesseinheit P1 in der in Figur 2a) gezeigten Form, bei der die Rückkontaktschicht des Moduls E mehrere (hier: 5 mit je 5 Spuren) einstrukturierte Spurengruppen SG1' bis SGm' mit entlang des Spurverlaufs variierenden Abständen Δ₂ aufweist.

Die der Prozesseinheit P1 nachfolgende zweite Prozesseinheit P2 dient nun der Feststellung der (verzerrten) Spurverläufe der Spurengruppen SG': Dazu weist die Prozesseinheit P2 der erfindungsgemäßen Strukturierungsvorrichtung eine Spurerfassungseinheit 3 auf, mit der die bereits im Solarmodul E vorhandenen Spuren hinsichtlich ihres Verlaufs bzw. ihrer Lage erfasst werden. Hierzu umfasst die Spurerfassungseinheit 3 ein Kamerasystem K, mit dem die Spurverläufe in den Spurengruppen SG1' bis SGm' aufgenommen und in ein digitales Bild umgesetzt werden. Alternativ dazu kann zur Aufnahme der Spurverläufe jedoch auch ein auf elektrische Effekte ausgelegter Sensor (z.B. eine Wirbelstromsonde) verwendet werden. Mit Hilfe einer der Kamera K nachgeschalteten Bildverarbeitungseinheit 5 wird das die Spuren zeigende Digitalbild mit an sich bekannten Mustererkennungsverfahren (z.B. Kantendetektionsverfahren) ausgewertet. Die ausgewerteten Informationen, insbesondere die entlang des Spurverlaufs variierenden Abstände Δ₂ der unterschiedlichen Spurengruppen SG' werden in einer Speichereinheit 6 der Spurerfassungseinheit 3 abgespeichert. Als Abstände Δ₂ können dabei jeweils die paarweisen Abstände benachbarter Spurengruppen SG' erfasst und abgespeichert werden; es ist jedoch selbstverständlich auch möglich, von jeder weiteren Spurengruppe (SG2' bis SGm') jeweils den Abstand Δ₂ zur ersten Spurengruppe SG1' zu erfassen und abzuspeichern. Wie in Figur 2a) angedeutet, ist es auch nicht unbedingt notwendig, ein digitales Bild des gesamten Spurverlaufs auf dem Solarmodul E abzubilden und auszuwerten: Wird die Prozesseinheit P2 beispielsweise in Form einer Transportvorrichtung (zum Transport des Solarmoduls E von der ersten Prozesseinheit P1 zur dritten Prozesseinheit P3) ausgebildet, so ist es ausreichend, den jeweiligen Spurverlauf an einer endlichen Anzahl von Stützstellen tᵢ (i = 1, 2, 3, ..., n, ...) zu erfassen und auszuwerten.

Die in der Speichereinheit 6 der Spurerfassungseinheit 3 niedergelegten Informationen über den Spurverlauf der einzelnen bereits eingebrachten Spuren der Spurengruppen SG' wird dann einer Spursteuereinheit 4 der der zweiten Prozesseinheit P2 nachfolgenden dritten Prozesseinheit P3 zur Verfügung gestellt. Die Informationen können hierbei entweder unmittelbar in Form der vorbeschriebenen Abstände Δ₂ zur Verfügung gestellt werden, es ist jedoch auch möglich, die Informationen in Form von aus diesen Abständen abgeleiteten Soll/Ist-Vergleichswerten bzw. in Form von Korrekturmatrizen, die den realen Verlauf der einzelnen Spuren der Spurengruppen relativ zum Idealverlauf dieser Spuren (Parallelität und konstanter Abstand aller einzelner Spuren im Modul E) ausweisen, zur Verfügung zu stellen. Mit Hilfe dieser Informationen steuert dann wie nachfolgend beschrieben die Spursteuereinheit 4 der dritten Prozesseinheit P3 der erfindungsgemäßen Strukturierungsvorrichtung S die Einbringung neuer Spuren bzw. Spurengruppen SG in die nach der Spurstrukturierung des Rückkontaktes in der Prozesseinheit P1 aufgebrachten Zwischenschichten des Moduls E. Wie Figur 2b) andeutet, ist der Datenaustausch zwischen der Spurerfassungseinheit 3 und der Spursteuereinheit 4 der Strukturierungsvorrichtung S bidirektional ("bi") ausgebildet, so dass auch beispielsweise für die Kameraführung verwendbare Informationen von der Spursteuereinheit 4 an die Spurerfassungseinheit 3 rückübertragbar sind.

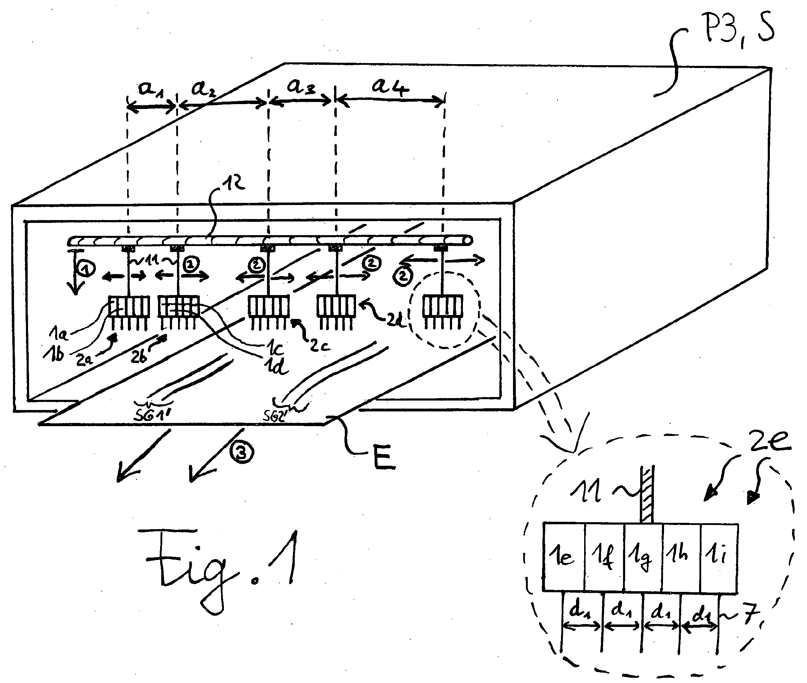

Figur 1 zeigt nun die dritte Prozesseinheit P3 der Strukturierungsvorrichtung S im Detail. Die die Ansteuerung der einzelnen Elemente 1, 2 initiierende und koordinierende Spursteuereinheit 4 (Rechnersystem) ist hier nicht gezeigt. Dargestellt sind somit lediglich die wesentlichen Funktionselemente dieser Prozesseinheit. Wie durch die Pfeile 3 angedeutet, wird das Solarmodul in Richtung des Spurverlaufs der bereits eingebrachten Spurengruppen SG1' bis SGm' (gezeigt sind hier nur zwei Spurengruppen) transportiert. Bei einer solchen Transportvorrichtung kann es sich beispielsweise um einen an sich bekannten Luftkissentisch handeln, auf dessen Luftpolster das Solarmodul E durch die Prozesseinheit P3 hindurchbewegt wird. Alternativ dazu können sich die Prozesseinheiten auch über ein feststehendes Solarmodul E bewegen. Die Prozesseinheit P3 weist nun insgesamt fünf einzelne, unabhängige Strukturierungseinheiten 2a bis 2e auf. Die Strukturierungseinheit 2e ist hierbei rechts unten in Figur 1 vergrößert skizziert. Jede dieser Strukturierungseinheiten 2a bis 2e ist mit einer beweglichen Halterung 11 an einer quer zur Transportrichtung angeordneten Schiene 12 aufgehängt. Die einzelnen Strukturierungseinheiten 2a bis 2e sind somit entlang der Schienenachse beabstandet voneinander in einer Reihe angeordnet. Jede der Halterungen 11 ist mit einer Motoreinheit (nicht gezeigt) versehen, welche durch die Spursteuereinheit 4 angesteuert werden kann. Die Motoreinheiten der einzelnen Strukturierungseinheiten sind dabei jeweils unabhängig voneinander ansteuerbar und die einzelnen Strukturierungseinheiten sind jeweils unabhängig voneinander entlang der Längsrichtung der Schiene 12, also senkrecht zur Transportrichtung (Pfeile 3) bewegbar. Auf diese Art und Weise können die Abstände a (entlang der Schienenlängsachsrichtung 12 gesehen) jeweils benachbarter Strukturierungseinheiten jeweils unabhängig voneinander eingestellt werden: In der gezeigten Momentanaufnahme haben die beiden Strukturierungseinheit 2a und 2b beispielsweise einen Abstand a₁, der etwa halb so groß ist wie der Abstand a₂ der beiden Strukturierungseinheiten 2b und 2c. Die einzelnen Strukturierungseinheiten sind somit mittels der Spursteuereinheit 4 und der Motoreinheiten in Richtung der Schienenlängsrichtung 12 (siehe Pfeilrichtung 2) unabhängig voneinander steuerbar.

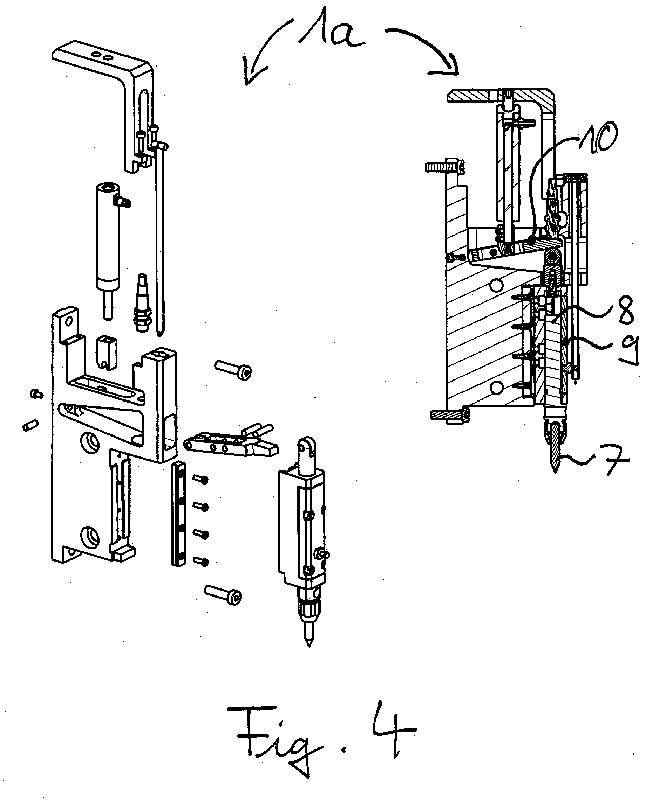

Jede einzelne Strukturierungseinheit 2 weist nun insgesamt fünf Strukturierungswerkzeuge 1 auf (separat bezeichnet sind hier nur zwei benachbarte Strukturierungswerkzeuge 1a und 1b bzw. 1c und 1d der ersten beiden Strukturierungseinheiten 2a und 2b sowie die fünf vergrößert skizzierten Strukturierungswerkzeuge 1e bis 1i der letzten Strukturierungseinheit 2e rechts im Bild). Die fünf einzelnen Strukturierungswerkzeuge der Strukturierungseinheiten sind hier als mechanische Strukturierungswerkzeuge 1 in Form von Ritzköpfen mit jeweils einer mechanischen Ritznadel 7 (vgl. Figur 4) ausgebildet. Benachbarte Ritzköpfe einer Strukturierungseinheit 2 sind dabei (vgl. Figur 1 rechts unten) jeweils mit konstantem, gleichem Abstand fest zueinander angeordnet. Zwei benachbarte Ritznadeln 7 sind somit jeweils im selben Abstand d₁ zueinander angeordnet. Der feste Abstand d₁ zwischen jeweils zwei benachbarten Ritznadeln 7 einer Strukturierungseinheit beträgt im vorliegenden Fall beispielsweise 15 mm. Mit Hilfe der jeweiligen Motoreinheit ist jede Strukturierungseinheit 2 senkrecht zur Schienenlängsachsrichtung (Pfeilrichtung 2) und senkrecht zur Vorschub- bzw. Transportrichtung des Moduls E (Pfeilrichtung 3) in Richtung auf das Modul E absenkbar (Pfeilrichtung 1).

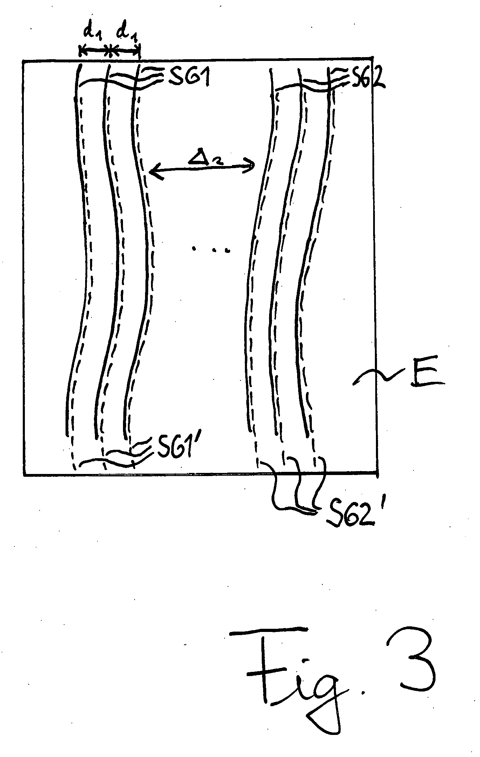

Die Funktionsweise der Prozesseinheit P3 der Strukturierungsvorrichtung S wird nun anhand von Figuren 1 und 3 beschrieben: Das Kamerabild der bereits eingebrachten Spuren bzw. Spurengruppen SG' wird von der Spursteuereinheit 4 zur Ansteuerung der Motoreinheiten der einzelnen Strukturierungseinheiten 2 verwendet. Die einzelnen Strukturierungseinheiten 2 werden mittels der Motoreinheiten auf das Solarmodul E bis zum Kontakt mit demselben abgesenkt (Pfeilrichtung 1). Die Anpresskräfte der Spitzen der Ritznadeln 7 der einzelnen Strukturierungswerkzeuge 1 sind dabei (innerhalb ein und derselben Strukturierungseinheit 2 wie auch zwischen unterschiedlichen Strukturierungseinheiten) unabhängig voneinander gemäß den jeweils lokal vorliegenden Bedingungen (z.B. lokale Härte der Schicht, in der die jeweilige Spur eingebracht werden soll) steuerbar. Mittels der Spursteuereinheit 4 wird jeder bereits eingebrachten Spurengruppe SG' genau eine Strukturierungseinheit 2 zugeordnet (beispielsweise wird der Spurengruppe SG1' in Figur 1 links die erste Strukturierungseinheit 2a zugeordnet). Anhand des aus dem Kamerabild bestimmten Spurenverlaufs einer bereits vorhandenen Spurengruppe SG' wird nun die ihr zugeordnete Strukturierungseinheit 2 so gesteuert, dass die von dieser Strukturierungseinheit 2 neu eingebrachte Spurengruppe SG hinsichtlich ihres Verlaufs exakt parallel zum Verlauf der bereits eingebrachten, zugehörigen Spurengruppe SG' ist (vgl. Figur 3). Jede einzelne Spur einer neu eingebrachten Spurengruppe SG verläuft daher exakt parallel und in exakt definiertem, konstantem Abstand von ihrer zugehörigen Spur der bereits eingebrachten Spurengruppe SG'. Hierbei wird wie vorbeschrieben angenommen, dass jeweils benachbarte Spuren der bereits eingebrachten Spuren einer Spurengruppe SG' jeweils parallel zueinander und in konstantem Abstand voneinander verlaufen (Δ₁ = konstant). Aufgrund der variablen Abstandssteuerung der einzelnen Abstände a₁ bis a₄ jeweils benachbarter Strukturierungseinheiten lassen sich diese Abstände somit den variierenden Abständen Δ₂ der einzelnen Spurengruppen voneinander anpassen: Es ist somit für alle Spurengruppen sichergestellt, dass sämtliche neu einzubringenden Spuren einer Spurengruppe SG jeweils parallel und in konstantem Abstand zu ihren zugeordneten Spuren einer bereits eingebrachten Spurengruppe SG' verlaufen, obwohl die Abstände Δ₂ variieren.

Figur 4 zeigt ein einzelnes Strukturierungswerkzeug 1 in Form eines Ritzkopfes mit mechanischer Ritznadel 7, wie es im vorbeschriebenen Ausführungsbeispiel eingesetzt wird.

Die Ansteuerung einer Ritznadel 7 bzw. die Festlegung des Anpressdruckes dieser Ritznadel 7 auf dem Solarmodul E wird hier mittels einer Nadelsteuereinheit 8, 9, 10 (aufweisend einen Nadelhalter mit Justierfunktion 8, der innerhalb eines Schlittens 9 zur senkrechten translatorischen Bewegung der Nadel ausgebildet ist) realisiert. Die Einheit 10 stellt einen Hebelarm dar, mit dem je nach Anschlusspunkt der Kraftbereich der Nadel 7 eingestellt werden kann.

Die Vorteile der vorliegenden Erfindung liegen insbesondere darin, dass auf einfache und effiziente Art und Weise, d.h. zeitlich parallel, eine Vielzahl von Spuren in ein bereits spurstrukturiertes Solarzellenelement eingebracht werden kann, wobei sich die neu eingebrachten Spuren am Verlauf der bisherigen Spuren orientieren. Darüberhinaus weist die vorliegende Erfindung den Vorteil auf, dass das mit der Spurerfassungseinheit erfasste und ausgewertete Kamerabild der bereits eingebrachten Spuren auf einfache Art und Weise den nachfolgenden Prozesseinheiten bzw. Strukturierungseinheiten der Strukturierungsvorrichtung zur Verfügung gestellt werden kann. Es ist somit möglich, einem individuellen, zu bearbeitenden Solarmodul über sämtliche Prozessschritte hinweg ein individuelles Kamerabild zuzuordnen, anhand dessen sämtliche dem ersten (spurstrukturierenden) Prozessschritt nachfolgende Prozessschritte gesteuert werden können.

## Patentansprüche

1. Strukturierungsvorrichtung für die Strukturierung eines plattenförmigen Elementes (E), insbesondere eines Solarmoduls und/oder eines Dünnschicht-Solarmoduls, umfassend
mehrere jeweils zum Einbringen einer Spur in das plattenförmiges Element ausgebildete Strukturierungswerkzeuge (1)
**gekennzeichnet durch**
eine erste mehrere dieser Strukturierungswerkzeuge aufweisende Strukturierungseinheit (2a), wobei mindestens zwei Strukturierungswerkzeuge (1a, 1b) dieser ersten Strukturierungseinheit so ausgebildet sind, dass mit ihnen zwei parallel zueinander und mit konstantem Abstand voneinander verlaufende erste Spuren in das plattenförmige Element einbringbar sind (SG1), sowie eine zweite mehrere dieser Strukturierungswerkzeuge aufweisende Strukturierungseinheit (2b), wobei mindestens zwei Strukturierungswerkzeuge (1c, 1d) dieser zweiten Strukturierungseinheit so ausgebildet sind, dass mit ihnen zwei parallel zueinander und mit konstantem Abstand voneinander verlaufende zweite Spuren in das plattenförmige Element einbringbar sind ( SG2), wobei die erste und/oder die zweite Strukturierungseinheit (2a, 2b) so ausgebildet und/oder steuerbar ist/sind, dass der Abstand der ersten Spurengruppe von der zweiten Spurengruppe variabel ausgestaltbar ist,
**dadurch gekennzeichnet, dass** mindestens zwei Strukturierungswerkzeuge (1) mindestens einer der Strukturierungseinheiten (2) hinsichtlich der Ausdehnung, der Tiefe und/oder der Form der durch sie in das plattenförmige Element einbringbaren Spuren unabhängig voneinander regelbar sind.

2. Strukturierungsvorrichtung nach dem vorhergehenden Anspruch
**gekennzeichnet durch**
mehr als zwei, bevorzugt vier bis sechs, wie die erste und die zweite Strukturierungseinheit ausgebildete Strukturierungseinheiten (2), wobei mindestens drei dieser Strukturierungseinheiten so ausgebildet und/oder steuerbar sind, dass die Abstände ihrer Spurengruppen (SG) relativ zueinander variabel ausgestaltbar sind,
wobei bevorzugt mindestens drei dieser Strukturierungseinheiten im Wesentlichen in einer Reihe angeordnet sind.

3. Strukturierungsvorrichtung nach einem der vorhergehenden Ansprüche,
**dadurch gekennzeichnet, dass**
mindestens eine der Strukturierungseinheiten (2), bevorzugt alle der Strukturierungseinheiten, mehr als zwei, bevorzugt vier bis sechs, einzelne Strukturierungswerkzeuge (1) so aufweist, dass mit ihnen mehr als zwei, bevorzugt vier bis sechs, parallel zueinander und mit konstantem Abstand voneinander verlaufende Spuren in das plattenförmige Element einbringbar sind,
wobei bevorzugt benachbart einbringbare Spuren jeweils denselben Abstand voneinander aufweisen.

4. Strukturierungsvorrichtung nach einem der vorhergehenden Ansprüche,
**dadurch gekennzeichnet, dass**
mindestens eines der Strukturierungswerkzeuge (1) ein mechanisches Strukturierungswerkzeug, insbesondere einen Ritzkopf mit einer mechanischen Ritznadel (7), umfasst.

5. Strukturierungsvorrichtung nach einem der vorhergehenden Ansprüche,
**dadurch gekennzeichnet, dass**
mindestens eines der Strukturierungswerkzeuge (1) eine Laserbearbeitungseinheit, insbesondere eine Laserbearbeitungseinheit aufweisend einen Laser mit einer daran angeschlossenen, bevorzugt eine Lichtleitfaser umfassenden Optik zum gezielten Einstrahlen des mit dem Laser erzeugten Laserlichts auf das plattenförmige Element, umfasst.

6. Strukturierungsvorrichtung nach einem der vorhergehenden Ansprüche
**gekennzeichnet durch**
eine Spurerfassungseinheit (3), mit der bereits im plattenförmige Element vorhandene Merkmale, insbesondere bereits in das plattenförmige Element eingebrachte Spuren und/oder Spurengruppen (SG'), hinsichtlich ihres Verlaufs, ihrer Lage und/oder ihrer Form erfassbar sind und
eine Spursteuereinheit (4), mit der die Einbringung von Spurengruppen (SG) durch die Strukturierungseinheiten auf Basis der erfassten Merkmale steuerbar ist,
wobei insbesondere der Abstand verschiedener Spurengruppen (SG1, SG2) voneinander auf Basis des erfassten Verlaufs der bereits eingebrachten Spuren und/oder Spurengruppen (SG1', SG2') variierbar ist.

7. Strukturierungsvorrichtung nach dem vorhergehenden Anspruch,
**dadurch gekennzeichnet, dass**
die Spurerfassungseinheit (3) eine optische Erfassungseinheit, insbesondere ein Kamerasystem (K), mit nachgeschalteter Bildverarbeitungseinheit (5) zur Auswertung von Bildern der erfassten vorhandenen Merkmale, insbesondere zur Mustererkennung von bereits in das plattenförmige Element eingebrachten Spuren und/oder Spurengruppen, aufweist.

8. Strukturierungsvorrichtung nach einem der beiden vorhergehenden Ansprüche,
**dadurch gekennzeichnet, dass**
die Spurerfassungseinheit (3) eine Speichereinheit (6) aufweist, mit der Informationen, insbesondere digitalisierte optische Bilddaten und/oder erkannte Muster von Spuren und/oder Spurengruppen, der erfassten vorhandenen Merkmale abspeicherbar sind, wobei die Einbringung der Spurengruppen durch die Strukturierungseinheiten auf Basis der abgespeicherten Informationen steuerbar ist.

9. Strukturierungsvorrichtung nach einem der vorhergehenden Ansprüche,
**dadurch gekennzeichnet, dass**
der variabel ausgestaltbare Abstand einer Spurengruppe zu einer anderen Spurengruppe der Abstand senkrecht zum Verlauf der Spuren innerhalb einer Spurengruppe ist.

10. Strukturierungsvorrichtung nach Ansprüche 1 oder 4, **dadurch gekennzeichnet, dass**
die Anpresskraft mindestens zweier mechanischer Strukturierungswerkzeuge mindestens einer der Strukturierungseinheiten unabhängig voneinander regelbar ist.

11. Strukturierungsvorrichtung nach Anspruch 5,
**dadurch gekennzeichnet, dass**
die Strahlenergie, die Strahlungsintensität und/oder das zeitliche Einstrahlungsprofil mindestens zweier Laserbearbeitungseinheiten mindestens einer der Strukturierungseinheiten unabhängig voneinander regelbar ist/sind.

12. Strukturierungsverfahren für die Strukturierung eines plattenförmigen Elementes (E), insbesondere eines Solarmoduls und/oder eines Dünnschicht-Solarmoduls, wobei
mit mehreren Strukturierungswerkzeugen (1) jeweils eine Spur in das plattenförmiges Element eingebracht wird,
**dadurch gekennzeichnet, dass**
mit mindestens zwei Strukturierungswerkzeugen (1a, 1b) einer ersten Strukturierungseinheit (2a), die mehrere dieser Strukturierungswerkzeuge aufweist, zwei parallel zueinander und mit konstantem Abstand voneinander verlaufende erste Spuren in das plattenförmige Element eingebracht werden (SG1), und dass mit mindestens zwei Strukturierungswerkzeugen (1c, 1d) einer zweiten Strukturierungseinheit (2b), die mehrere dieser Strukturierungswerkzeuge aufweist, zwei parallel zueinander und mit konstantem Abstand voneinander verlaufende zweite Spuren in das plattenförmige Element eingebracht werden ( SG2), wobei die erste und/oder die zweite Strukturierungseinheit (2a, 2b) so ausgebildet und/oder gesteuert wird/werden, dass der Abstand der ersten Spurengruppe von der zweiten Spurengruppe variabel ausgestaltet wird,
**dadurch gekennzeichnet, dass** eine Strukturierungsvorrichtung nach einem der Ansprüche 1 bis 11 zum Einbringen von Spuren eingesetzt wird.

13. Verwendung einer Strukturierungsvorrichtung oder eines Strukturierungsverfahrens nach einem der vorhergehenden Ansprüche zum Einbringen von Spuren in Solarzellenmodule, insbesondere in Dünnschicht-Solarzellenmodule in Form von CIS- oder CIGS-Dünnschicht-Solarzellenmodulen.

## Claims

1. Structuring device for structuring a plate-shaped element (E), in particular a solar module and/or a thin-film solar module, comprising:
a number of structuring tools (1) designed for introducing a track into the plate-shaped element,
**characterized by**
a first structuring unit (2a), having a number of these structuring tools, at least two structuring tools (1a, 1b) of this first structuring unit being designed in such a way that, with them, two first tracks running parallel to one another and at a constant distance from one another can be introduced into the plate-shaped element (SG1),
and a second structuring unit (2b), having a number of these structuring tools, at least two structuring tools (1c, 1d) of this second structuring unit being designed in such a way that, with them, two second tracks running parallel to one another and at a constant distance from one another can be introduced into the plate-shaped element (SG2),
the first and/or second structuring unit (2a, 2b) being designed and/or controllable in such a way that the distance of the first group of tracks from the second group of tracks can be formed variably,
**characterized in that** at least two structuring tools (1) of at least one of the structuring units (2) can be controlled independently of one another with regard to the extent, the depth and/or the form of the tracks that can be introduced by it into the plate-shaped element.

2. Structuring device according to the preceding claim,
**characterized by**
more than two, preferably four to six, structuring units (2) designed like the first and second structuring units, at least three of these structuring units being designed and/or controllable in such a way that the distances of their groups of tracks (SG) in relation to one another can be formed variably,
preferably at least three of these structural units being arranged substantially in a row.

3. Structuring device according to one of the preceding claims,
**characterized in that**
at least one of the structuring units (2), preferably all of the structuring units, has/have more than two, preferably four to six, individual structuring tools (1) in such a way that, with them, more than two, preferably four to six, tracks running parallel to one another and at a constant distance from one another can be introduced into the plate-shaped element,
wherein, preferably, adjacently introducible tracks respectively have the same distance to each other.

4. Structuring device according to one of the preceding claims,
**characterized in that**
at least one of the structuring tools (1) comprises a mechanical structuring tool, in particular a scoring head with a mechanical scoring needle (7).

5. Structuring device according to one of the preceding claims,
**characterized in that**
at least one of the structuring tools (1) comprises a laser machining unit, in particular a laser machining unit having a laser with an optical system connected thereto, preferably comprising a light-conducting fibre, for targeted radiation of the laser light generated with the laser onto the plate-shaped element.

6. Structuring device according to one of the preceding claims,
**characterized by**
a track detection unit (3), with which features already existing in the plate-shaped element, in particular tracks and or groups of tracks (SG') already introduced into the plate-shaped element, can be detected with respect to their path, their position and/or their form, and
a track control unit (4), with which the introduction of groups of tracks (SG) by the structuring units can be controlled on the basis of the features detected,
in particular the distance of different groups of tracks (SG1, SG2) from one another being variable on the basis of the detected path of the already introduced tracks and/or groups of tracks (SG1', SG2').

7. Structuring device according to one of the preceding claims,
**characterized in that**
the track detection unit (3) has an optical detection unit, in particular a camera system (K), with a downstream image processing unit (5) for evaluating images of the existing features detected, in particular for pattern recognition of tracks and/or groups of tracks already introduced into the plate-shaped element.

8. Structuring device according to one of the two preceding claims,
**characterized in that**
the track detection unit (3) has a memory unit (6), with which information, in particular digitized optical image data and/or detected patterns of tracks and/or groups of tracks, of the existing features detected can be stored, wherein the introduction of the groups of tracks by the structuring units is controllable on the basis of the stored information.

9. Structuring device according to one of the preceding claims,
**characterized in that**
the variably formable distance of one group of tracks from another group of tracks is the distance perpendicular to the path of the tracks within a group of tracks.

10. Structuring device according to Claim 1 or 4,
**characterized in that**
the pressing force of at least two mechanical structuring tools of at least one of the structuring units can be controlled independently of one another.

11. Structuring device according to Claim 5,
**characterized in that**
the beam energy, the radiation intensity and/or the temporal radiation profile of at least two laser machining units of at least one of the structuring units is/are controllable independently of one another.

12. Structuring process for the structuring of a plate-shaped element (E), in particular a solar module and/or a thin-film solar module, wherein,
with a number of structuring tools (1), a track being respectively introduced into the plate-shaped element,
**characterized in that**
with at least two structuring tools (1a, 1b) of a first structuring unit (2a), which has a number of these structuring tools, two first tracks running parallel to one another and at a constant distance from one another are introduced into the plate-shaped element (SG1), and
with at least two structuring tools (1c, 1d) of a second structuring unit (2b), which has a number of these structuring tools, two second tracks running parallel to one another and at a constant distance from one another are introduced into the plate-shaped element (SG2),
wherein the first and/or the second structuring unit (2a, 2b) is/are formed and/or controlled in such a way that the distance of the first group of tracks from the second group of tracks is formed variably,
**characterized in that** a structuring device according to one of Claims 1 to 11 is used for introducing tracks.

13. Use of a structuring device or a structuring process according to one of the preceding claims for introducing tracks in solar cell modules, in particular in thin-film solar cell modules in the form of CIS or CIGS thin-film solar cell modules.

## Revendications

1. Dispositif de structuration pour la structuration d'un élément en forme de plaque (E), plus particulièrement d'un module photovoltaïque et/ou d'un module photovoltaïque en couche mince, comprenant
plusieurs outils de structuration (1) conçus pour la réalisation d'une piste dans l'élément en forme de plaque,
**caractérisé par**
une première unité de structuration (2a) comprenant plusieurs de ces outils de structuration, au moins deux outils de structuration (1a, 1b) de cette première unité de structuration étant conçus de façon à permettre la réalisation de deux premières pistes parallèles entre elles et à une distance constante entre elles dans l'élément en forme de plaque (SG1),
ainsi qu'une deuxième unité de structuration (2b) comprenant plusieurs de ces outils de structuration, au moins deux outils de structuration (1c, 1d) de cette deuxième unité de structuration étant conçus de façon à permettre la réalisation de deux deuxièmes pistes parallèles entre elles et à une distance constante entre elles dans l'élément en forme de plaque (SG2),
la première et/ou la deuxième unité de structuration (2a, 2b) étant conçue(s) et/ou contrôlable(s) de façon à ce que la distance entre le premier groupe de pistes et le deuxième groupe de pistes soit variable,
**caractérisé en ce qu'**au moins deux outils de structuration (1) d'au moins une des unités de structuration (2) peuvent être réglés indépendamment entre eux en ce qui concerne l'étendue, la profondeur et/ou la forme des pistes pouvant être réalisées à l'aide de ceux-ci dans l'élément en forme de plaque.

2. Dispositif de structuration selon la revendication précédente,
**caractérisé par**
plus de deux, de préférence quatre à six, unités de structuration (2) conçues comme la première et la deuxième unité de structuration, au moins trois de ces unités de structuration étant conçues et/ou contrôlables de façon à ce que les distances entre leurs groupes de pistes (SG) soient variables,
de préférence au moins trois de ces unités de structuration étant disposées globalement en une rangée.

3. Dispositif de structuration selon l'une des revendications précédentes,
**caractérisé en ce que**
au moins une des unités de structuration (2), de préférence toutes les unités de structuration, comprennent plus de deux, de préférence de quatre à six, outils de structuration (1) individuels, de façon à permettre la réalisation de plus de deux, de préférence de quatre à six, pistes parallèles entre elles et à une distance constante entre elles, dans l'élément en forme de plaque,
de préférence, des pistes réalisées de manière adjacente présentant la même distance entre elles.

4. Dispositif de structuration selon l'une des revendications précédentes,
**caractérisé en ce que**
au moins un des outils de structuration (1) comprend un outil de structuration mécanique, plus particulièrement une tête de gravure avec une aiguille de gravure mécanique (7).

5. Dispositif de structuration selon l'une des revendications précédentes,
**caractérisé en ce que**
au moins un des outils de structuration (1) comprend une unité d'usinage laser, plus particulièrement une unité d'usinage laser comprenant un laser avec une optique reliée à celui-ci, de préférence, une fibre optique, pour l'irradiation ciblée de la lumière laser générée par le laser sur l'élément en forme de plaque.

6. Dispositif de structuration selon l'une des revendications précédentes,
**caractérisé par**
une unité de mesure de piste (3), avec laquelle les caractéristiques déjà existantes dans l'élément en forme de plaque, plus particulièrement les pistes et/ou groupes de pistes (SG') déjà réalisées dans l'élément en forme de plaque, peuvent être mesurées en ce qui concerne leur étendue, leur position et/ou leur forme et
une unité de contrôle de pistes (4) avec laquelle la réalisation de groupes de pistes (SG) par les unités de structuration peut être contrôlée sur la base des caractéristiques mesurées,
plus particulièrement la distance entre les différents groupes de pistes (SG1, SG2) pouvant être modifiée sur la base de l'étendue mesurée des pistes et/ou des groupes de pistes (SG1', SG2') déjà réalisées.

7. Dispositif de structuration selon la revendication précédente,
**caractérisé en ce que**
l'unité de mesure de pistes (3) comprend une unité de mesure optique, plus particulièrement un système de caméra (K), avec une unité de traitement d'image (5) connectée en aval, pour l'analyse d'images des caractéristiques existantes mesurées, plus particulièrement pour la détection de motifs de pistes et/ou de groupes de pistes déjà réalisées dans l'élément en forme de plaque.

8. Dispositif de structuration selon l'une des deux revendications précédentes,
**caractérisé en ce que**
l'unité de mesure de pistes (3) comprend une unité de mémoire (6) avec laquelle des informations, plus particulièrement des données d'images optiques numérisées, et/ou des motifs détectés de pistes et/ou de groupes de pistes des caractéristiques existantes mesurées peuvent être enregistrées, la réalisation des groupes de pistes par les unités de structuration pouvant être contrôlée sur la base des informations enregistrées.

9. Dispositif de structuration selon l'une des revendications précédentes,
**caractérisé en ce que**
la distance variable entre un groupe de pistes et un autre groupe de pistes étant la distance perpendiculairement à l'étendue des pistes à l'intérieur d'un groupe de pistes.

10. Dispositif de structuration selon la revendication 1 ou 4,
**caractérisé en ce que**
les forces de pression d'au moins deux outils de structuration mécaniques d'au moins une des unités de structuration pouvant être régulées indépendamment entre elles.

11. Dispositif de structuration selon la revendication 5,
**caractérisé en ce que**
l'énergie de rayonnement, l'intensité du rayonnement et/ou le profil temporel d'irradiation d'au moins deux unités d'usinage au laser d'au moins une des unités de structuration pouvant être régulée(s) indépendamment entre elles.

12. Procédé de structuration pour la structuration d'un élément en forme de plaque (E), plus particulièrement d'un module photovoltaïque et/ou d'un module photovoltaïque en couche mince,
plusieurs outils de structuration (1) réalisant respectivement une piste dans l'élément en forme de plaque,
**caractérisé en ce que**,
avec au moins deux outils de structuration (1a, 1b) d'une première unité de structuration (2a), qui comprend plusieurs de ces outils de structuration, deux premières pistes, parallèles entre elles et avec une distance constante entre elles, sont réalisées dans l'élément en forme de plaque (SG1) et
avec au moins deux outils de structuration (1c, 1d) d'une deuxième unité de structuration (2b), qui comprend plusieurs de ces outils de structuration, deux deuxièmes pistes, parallèles entre elles et avec une distance constante entre elles, sont réalisées dans l'élément en forme de plaque (SG2),
la première et/ou la deuxième unité de structuration (2a, 2b) étant conçue(s) et/ou contrôlée(s) de façon à ce que la distance entre le premier groupe de pistes et le deuxième groupe de pistes soit variable,
**caractérisé en ce qu'**un dispositif de structuration selon l'une des revendications 1 à 11 est utilisé pour la réalisation des pistes.

13. Utilisation d'un dispositif de structuration ou d'un procédé de structuration selon l'une des revendications précédentes, pour la réalisation de pistes dans des modules photovoltaïques, plus particulièrement des modules photovoltaïques à couches minces, sous la forme de modules photovoltaïques à couches minces CIS ou CGIS.
